Europäisches Patentamt

(19) European Patent Office

Office européen des brevets

(11) Numéro de publication: **0 070 206**
**B1**

(12) **FASCICULE DE BREVET EUROPEEN**

(45) Date de publication du fascicule du brevet: **02.09.87**

(21) Numéro de dépôt: **82400333.9**

(22) Date de dépôt: **26.02.82**

(51) Int. Cl.⁴: **C 08 F 220/12,** H 01 L 31/02, C 08 F 220/18 // (C08F220/12, 220:18, 220:14),(C08F220/18, 220:12, 220:14)

(54) Prépolymère acrylique et son application à l'encapsulation de photopiles.

(30) Priorité: **05.03.81 FR 8104392**

(43) Date de publication de la demande:
**19.01.83 Bulletin 83/03**

(45) Mention de la délivrance du brevet:
**02.09.87 Bulletin 87/36**

(84) Etats contractants désignés:
**AT BE CH DE FR GB IT LI LU NL SE**

(56) Documents cités:
**FR-A-1 369 063**
**FR-A-2 394 895**
**US-A-4 175 176**

(73) Titulaire: **ALTULOR S.A.**
**Tour Gan - Place de l'Iris**
**F-92082 Paris la Defense (FR)**

(72) Inventeur: **Avenel, Michel**
**107, Le Pré Langlois**
**F-27140 Gisors (FR)**
Inventeur: **Evrard, Paul Jean-Dominique**
**16, Impasse de la Couture**
**F-78112 Fourqueux (FR)**
Inventeur: **Leca, Jean-Paul**
**224, Bd du Maréchal Juin**
**F-78200 Mantes la Jolie (FR)**

(74) Mandataire: **Dubost, Thierry**
**SOCIETE CHIMIQUE DES CHARBONNAGES**
**Service Propriété Industrielle B.P. 57**
**F-62670 Mazingarbe (FR)**

Courier Press, Leamington Spa, England.

**0 070 206**

## Description

La présente invention concerne un prépolymère acrylique et son application à l'encapsulation de photopiles.

Un problème rencontré dans la fabrication de panneaux pour l'utilisation de l'énergie solaire, dits panneaux solaires, concerne l'encapsulation des photopiles constituant lesdits panneaux. On recherche à cet effet un metériau transparent, souple et résistant bien au viellissement sous l'effet de la température et/ou de l'humidité.

Dans le cours de ses recherches, le demandeur a mis au point un prépolymère acrylique qui s'est révélé efficace pour l'encapsulation de photopiles comme décrit ci—après de manière détaillée.

Le prépolymère acrylique selon l'invention a une viscosité de 0,15 à 1 Pa·s et comprend:

(a)—de 10 à 50 parties en poids de motifs dérivés d'au moins un acrylate d'alkyle, le groupe alkyle ayant de 4 à 12 atomes de carbone,

(b)—de 30 à 60 parties en poids de motifs dérivés d'au moins un méthacrylate d'alkyle, le groupe alkyle ayant de 1 à 5 atomes de carbone, et

(c)—de 10 à 40 parties en poids de motifs dérivés de l'acrylate de méthyle, la somme (a)+(b)+(c) étant égale à 100 parties en poids.

Le prépolymère selon l'invention est un liquide de densité à 20°C comprise entre 0,960 et 0,975 et d'indice de réfraction compris entre 1,43 et 1,44. Il peut comporter en outre de 20 à 200 ppm (parties par million) d'un inhibiteur de polymérisation. Le procédé de fabrication du prépolymère selon l'invention consiste à copolymériser, en présence d'un initiateur de radicaux libres et d'un agent de transfert de chaîne, (a) de 10 à 50 parties en poids d'au moins un acrylate d'alkyle, le groupe alkyle ayant de 4 à 12 atomes de carbone, (b) de 30 à 60 parties en poids d'au moins un méthacrylate d'alkyle, le groupe alkyle ayant de 1 à 5 atomes de carbone et (c) de 10 à 40 parties en poids d'acrylate de méthyle, à une température comprise entre 60° et 85°C et jusqu'à l'obtention d'une viscosité comprise entre 0,15 à 1 Pa.s (1,5 et 10 poises). Comme agent de transfert de chaîne, on peut utiliser par exemple un mercaptan tel que le laurylmercaptan à raison de 0,1 à 1% en poids par rapport à l'ensemble des comonomères. Comme initiateur de radicaux libres on peut utiliser par exemple un composé azoïque ou bien un peroxyde tel que le peroxyde de lauryle à raison de 0,2 à 2% en poids par rapport à l'ensemble des comonomères. La fabrication du prépolymère selon l'invention peut éventuellement être effectuée en présence d'un agent réticulant—tel que par exemple le diacrylate ou le diméthacrylate de triéthylène glycol, le diméthacrylate d'éthylène glycol ou le diacrylate de butanediol—et/ou d'au moins un quatrième comonomère choisi parmi l'acide acrylique, l'acide méthacrylique ou le monométhacrylate d'éthylène glycol.

Une application intéressante du prépolymère selon l'invention consiste à encapsuler des photopiles dans une résine souple et transparente obtenue par mèlange de:

100 parties du prépolymére décrit précédemment,

de 0,1 à 4 parties d'un arènesulfonate de vanadium, et

de 0,5 à 4 parties d'un initiateur de radicaux libres,

à une température comprise entre 10° et 70°C et pendant un temps suffisant pour obtenir la solidification du polymère à la température considérée.

La résine solide ainsi obtenue a une densité à 20°C comprise entre 1,10 et 1,12, un indice de réfraction (déterminé selon la norme ISO R 489) compris entre 1,47 et 1,48 et une dureté Shore A (déterminée selon la norme ISO R 868) comprise entre 20 et 35. Elle se caractérise par une résistance remarquable aux agents atmosphériques et notamment au vieillissement sous l'effet de la température et/ou de l'humidité.

L'arènesulfonate de vanadium utilisé en mélange avec le prépolymère peut être préalablement dispersé dans un diluant tel que par exemple le phtalate de méthyle. L'initiateur de radicaux libres est choisi parmi les peroxydes et peresters décomposables à la tempétature considérée tels que par exemple le peroxyde de méthyléthylcétone, le peroxyde de cyclohexanone, le peroxyde d'acétylcétone, l'hydroperoxyde de tertiobutyle, le peroxycarbonate de butylisopropyle et, le peroctoate de tertiobutyle. La durée nécessaire pour obtenir la solidification du polymére varie généralement de 1 à 24 heures selon la température considérée.

Dans l'application selon l'invention, les photopiles—reliées entre elles par des fils conducteurs—sont généralement positionnées d'abord sur une plaque support, puis on coule le mélange précédemment décrit dans l'espace situé entre ladite plaque support et une seconde plaque protectrice—lequel espace peut avoir une dimension de l'ordre de 1 à 10 mm—et l'on maintient l'ensemble du dispositif dans une enceinte à la température désirée pendant le temps nécessaire. Les plaques délimitant l'espace dans lequel on coule le mélange peuvent être consituées en différents matériaux tels que verre, métal ou résine synthétique comme le polyméthacrylate de méthyle. On obtient ainsi une encapsulation parfaitement sûre des photopiles constituant les panneaux destinés à l'utilisation de l'énergie solaire.

Les exemples suivants illustrent de manière non limitative des modes de réalisation de la présente invention.

Exemple 1
Fabrication du prépolymère acrylique

On prépolymèrise, en présence de 0,4% de lauryl-mercaptan et de 0,2% de peroxyde de lauryle, un

2

mélange de monomères constitué de 31% en poids d'acrylate de 2-éthylhexyle, 47% en poids de méthacrylate d'éthyle et de 22% en poids d'acrylate de méthyle. Cette réaction est effectuée à la température de 75°C pendant une durée de 90 minutes.

Le prépolymère obtenu est stabilisé à l'aide de 40 ppm d'un inhibiteur commercialisé sous le nom Topanal A®

Le prépolymère obtenu est caractérisé par les propriétés physiques suivantes:

| | |
|---|---|
| Indice de réfraction (norme ISO R 489) | 1,435 |
| Densité à 20°C (norme ISO 11—83) | 0,968 |
| Viscosité | 0,17 Pa · s (1,7 poises) |

Exemple 2

Application du prépolymère à l'encapsulation

On positionne des photopiles sur une plaque support puis on coule dans l'espace situé entre ladite plaque support et une seconde plaque protectrice, une couche de 3 mm d'épaisseur d'un mélange constitué de:

100 parties en poids du prépolymère obtenu conformément à l'exemple 1,

2 parties en poids d'un mélange de peroxyde de cyclohexanone et de peroctoate de tertiobutyle en solution dans le phtalate de méthyle.

2 parties en poids de toluènesulfonate de vanadyle en solution dans le phtalate de méthyle.

Le mélange est maintenu dans cet espace à la température de 20°C pendant 24 heures. A l'issue de cette durée, les photopiles se trouvent encapsulées dans un polymère solide dont les propriétés sont déterminées ci-après.

Exemple 3

Propriétés du polymère

Un prélèvement immédiat du polymère obtenu par coulée conformément à l'exemple 2 permet de déterminer les propriétés physiques suivantes:

| | |
|---|---|
| Indice de réfraction (norme ISO R 489) | 1,475 |
| Densité à 20°C (norme ISO 11—83) | 1,11 |
| Dureté Shore A (norme ISO R 868) | 28 |
| Souplesse | 148 secondes |

La souplesse est mesurée par compression sur un appareil de traction, la valeur indiquée étant le temps en secondes mis pour comprimer l'éprouvette jusqu'à une charge de 40 kg à une vitesse de 1,5 mm/min.

D'autre part on soumet le polymère à un test de vieillissement dans une enceinte climatisée remplie d'air chaud (50°C) ayant un taux d'humidité de 50%. La transmission lumineuse mesurée après un séjour de 20 jours dans cette enceinte est de 94%. On soumet également le polymère à un test de vieillissement dans l'eau en l'immergeant dans une cuve d'eau chaude (50°C). La souplesse mesurée après un séjour de 20 jours dans cette cuve est de 148 secondes. On peut donc remarquer que le polymère présente une bonne tenue au vieillissement sous l'effet d'agents tels que la température et l'humidité.

**Revendications**

1. Prépolymère acrylique de viscosité comprise entre 0,15 et 1 Pa.s., comprenant:

(a) de 10 à 50 parties en poids de motifs dérivés d'au moins un acrylate d'alkyle, le groupe alkyle ayant de 4 à 12 atomes de carbone,

(b) de 30 à 60 parties en poids de motifs dérivés d'au moins un mèthacrylate d'alkyle, le groupe alkyle ayant de 1 à 5 atomes de carbone, et

(c) de 10 à 40 parties de motifs dérivés de l'acrylate de méthyle, la somme (a)+(b)+(c) étant égale à 100 parties en poids.

2. Prépolymére selon la revendication 1, caractérisé en ce que sa densité à 20°C est comprise entre 0,960 et 0,975.

3. Prépolymère selon l'une des revendications 1 et 2, caractéisé en ce que son indice réfraction est compris entre 1,43 et 1,44.

4. Prépolymère selon l'une des revendications 1 à 3, caractérisé en ce qu'il comprend en outre de 20 à 200 ppm d'un inhibiteur de polymèrisation.

5. Prépolymère selon l'une des revendications 1 à 4, caractérisé en ce qu'il comprend en outre des motifs dérivés d'un quatrième comonomère choisi parmi l'acide acrylique, l'acide méthacrylique ou le monométhacrylate d'éthylène glycol.

6. Procédé de fabrication du prépolymère acrylique selon la revendication 1, caractérisé en ce qu'on copolymérise, en présence d'un initiateur de radicaux libres et d'un agent de transfert de chaîne, (a) de 10 à 50 parties en poids d'au moins un acrylate d'alkyle, le groupe alkyle ayant de 4 à 12 atomes de carbone, (b)

de 30 à 60 parties en poids d'au moins un méthacrylate d'alkyle, le groupe alkyle ayant de 1 à 5 atomes de carbone et (c) de 10 à 40 parties en poids d'acrylate de méthyle, la somme (a)+(b)+(c) étant égale à 100 parties en poids, à une température comprise entre 60° et 85°C et jusqu'à l'obtention d'une viscosité comprise entre 0,15 et 1 Pa.s.

7. Application du prépolymère acrylique selon la revendication 1 à l'encapsulation de photopiles, reliées entre elles par des fils conducteurs et positionnées sur une plaque support, par coulée d'une résine dans l'espace situé entre ladite place support et une seconde plaque protectrice, caractérisée en ce que ladite résine est obtenue par mélange de 100 parties du prépolymère acrylique selon la revendication 1, de 0,1 à 4 parties d'un arénesulfonate de vanadium et de 0,5 à 4 parties d'un initiateur de radicaux libres, à une température comprise entre 10° et 70°C et pendant un temps suffisant pour obtenir la solidification de la résine polymère à la température considérée.

8. Application selon la revendication 7, caractérisée en ce que le temps suffisant pour obtenir la solidification de la résine est compris entre 1 et 24 heures.

9. Application selon l'une des revendications 7 et 8, caractérisée en ce que la résine polymère obtenue a une densité à 20°C comprise entre 1,10 et 1,12 et un indice de réfraction compris entre 1,47 et 1,48.

10. Application selon l'une des revendications 7 à 9, caractérisée en ce que la résine polymère obtenue a une dureté Shore A comprise entre 20 et 35.

## Patentansprüche

1. Acryl-Vorpolymerisat mit einer Viskosität zwischen 0,15 und 1 Pa.s, enthaltend:

(a) 10 bis 50 Gewichtsteile an von mindestens einem Alkylacrylat abstammenden Einheiten, wobei die Alkylgruppe 4 bis 12 Kohlenstoffatome besitzt; (b) 30 bis 60 Gewichtsteile an von mindestens einem Alkylmethacrylat abstammenden Einheiten, wobei die Alkylgruppe 1 bis 5 Kohlenstoffatome besitzt, und (c) 10 bis 40 Gewichtsteile an von Methylacrylat abstammenden Einheiten, wobei die Summe (a)+(b)+(c) 100 Gewichtsteile ausmacht.

2. Vorpolymerisat nach Anspruch 1, dadurch gekennzeichnet, daß seine Dichte bei 20°C zwischen 0,960 und 0,975 beträgt.

3. Vorpolymerisat nach Anspruch 1 oder 2, dadurch gekennzeichnet, daß sein Brechungsindex zwischen 1,43 und 1,44 beträgt.

4. Vorpolymerisat nach einem der Ansprüche 1 bis 3, dadurch gekennzeichnet, daß es weiters 20 bis 200 ppm eines Polymerisationsinhibitors enthält.

5. Vorpolymerisat nach einem der Ansprüche 1 bis 4, dadurch gekennzeichnet, daß es weiters von einem vierten Comonomer abstammede Einheiten enthält, welches Comonomer ausgewählt ist aus der Gruppe bestehend aus Acrylsäure, Methacrylsäure und Äthylenglykolmonomethacrylat.

6. Verfahren zur Herstellung des Acryl-Vorpolymerisats nach Anspruch 1, dadurch gekennzeichnet, daß man in Gegenwart eines Initiators in Form freier Radikale und eines Kettenübertragungsmittels (a) 10 bis 50 Gewichtsteile mindestens eines Alkylacrylats, dessen Alkylgruppe 4 bis 12 Kohlenstoffatome besitzt, (b) 30 bis 60 Gewichtsteile mindestens eines Alkylmethacrylats, dessen Alkylgruppe 1 bis 5 Kohlenstoffatome besitzt, une (c) 10 bis 40 Gewichtsteile Methylmethacrylat wobei die Summe (a)+(b)+(c) 100 Gewichtsteile ausmacht, bei einer Temperatur zwischen 60° un 85°C und bis zum Effeichen einer Viskosität zwischen 0,15 und 1 Pa.s. cypolymerisiert.

7. Anwendung des Acryl-Vorpolymerisats nach Anspruch 1 beim Einkapseln von untereinander durch Leitungsdrähte verbundenen und auf einer Trägerplatte angeordneten Photozellen durch Eingießen eines Harzes in den zwischen der genannten Trägerplatte und einer zweiten Schutzplatte gelegenen Raum, dadurch gekennzeichnet, daß das genannte Harz durch Mischen von 100 Teilen des Acryl-Vorpolymerisats nach Anspruch 1 mit 0,1 bis 4 teilen eines Vanadiumarensulfonats und 0,5 bis 4 Teilen eines Initiators in Form freier Radikale bei einer Temperatur zwischen 10° und 70°C und für eien zur Erzielung der Verfestigung des Polymerharzes bei der in Betracht gezogenen Temperatur ausreichende Zeitspanne erhalten wird.

8. Anwendung nach Anspruch 7, dadurch gekennzeichnet, daß die zur Erzeilung der Verfestiung des Harzes ausreichende Zeitspanne zwischen 1 und 24 Stunden beträgt.

9. Anwendung nach Anspruch 7 oder 8, dadurch gekennzeichnet, daß das erhaltene Polymerharz eine Dichte bei 20°C zwischen 1,10 und 1,12 und einen Brechungsindex zwischen 1,47 und 1,48 besitzt.

10. Anwendung nach einem der Ansprüche 7 bis 9, dadurch gekennzeichnet, daß das erhaltene Polymerharz eine Shore A—Härte zwischen 20 und 35 besitzt.

## Claims

1. An acrylic prepolymer having a viscosity between 0.15 and 1 Pa.s., comrising:

(a) from 10 to 50 parts by weight of units derived from at least one alkyl acrylate, the alkyl group having from 4 to 12 carbon atoms,

(b) from 30 to 60 parts by weight of units derived from at least one alkyl methacrylate, the alkyl group having from 1 to 5 carbon atoms, and

(c) from 10 to 40 parts by weight of units derived from methyl acrylate, the sum (a)+(b)+(c) being equal to 100 parts by weight.

2. A prepolymer according to claim 1, characterized in that its density at 20°C is between 0.960 and 0.975.

3. A prepolymer according to claim 1 or 2, characterized in that its refractive index is between 1.43 and 1.44.

4. A prepolymer according to one of claims 1 to 3, further comprising from 20 to 200 ppm of a polymerization inhibitor.

5. A prepolymer according to one of claims 1 to 4, further comprising units derived from a fourth comonomer selected from acrylic acid, methacrylic acid, and ethylene glycol monomethacrylate.

6. A process for the manufacture of the acrylic prepolymer according to claim 1, comprising copolymerizing, in the presence of a free-radical initiator and a chain transfer agent.

(a) from 10 to 50 parts by weight of at least one alkyl acrylate, the alkyl group having from 4 to 12 carbon atoms,

(b) from 30 to 60 parts by weight of at least one alkyl methacrylate, the alkyl group having from 1 to 5 carbon atoms, and

(c) from 10 to 40 parts by weight of methyl acrylate.

the sum (a)+(b)+(c) being equal to 100 parts by weight, at a temperature between 60° and 85°C., until a viscosity of between 1.5 and 10 poises is obtained.

7. Application of the acrylic prepolymer according to claim 1 to encapsulating photocells, connected to one another by conducting wires and positioned on a support plate, by casting a resin into the space located between the said support plate and a second protective plate, characterized in that the said resin is obtained by mixing 100 parts of the acrylic prepolymer according to claim 1, from 0.1 to 4 parts of a vanadium arenesulphonate and from 0.5 to 4 parts of a free-radical initiator at a temperature between 10° and 70°C and for a time sufficient to obtain solidification of the polymeric resin at the said temperature.

8. Application according to claim 7, characterized in that the time sufficient to obtain solidification of the resin is between 1 and 24 hours.

9. Application according to one of claims 7 and 8, characterized in that the polymeric resin obtained has a density at 20°C between 1.10 and 1.12 and a refractive index between 1.47 and 1.48.

10. Application according to one of claims 7 to 9, chacracterized in that the polymeric resin obtained has a Shore A hardness between 20 and 35.